# EUROPEAN PATENT SPECIFICATION

(11) **EP 0 278 629 B1**
(45) Date of publication and mention of the grant of the patent: **12.05.1993**
(21) Application number: 88300655.3
(22) Date of filing: 27.01.1988
(51) Int. Cl.: C23C 14/06, C23C 30/00

(54) **Amorphous materials**
Amorphe Werkstoffe
Matériaux amorphes

(30) Priority: 30.01.1987 JP 18631/87
(43) Date of publication of application: 17.08.1988
(73) Proprietor: Hitachi Maxell Ltd., Osaka-fu (JP)
(72) Inventor: Maro, Tsuyoshi, Yuki-gun Ibaraki-ken (JP); Fujiwara, Hideo, Kitasoma-gun Ibaraki-ken (JP); Kitakami, Osamu, Toride-shi (JP)
(74) Representative: Senior, Alan Murray

(56) References cited:
- DE-A- 2 511 047
- THIN SOLID FILMS, vol. 105, no. 1, July 1983, Elsevier Sequoia, Lausanne (CH); Y.ASANO, pp. 1-8: "Metal-containing plasma-polymerized films"
- SOLAR ENERGY MATERIALS, vol. 15, no. 1, January 1987, Elsevier Science Publishers B.V., Amsterdam (NL); L.MARTINU, pp. 21-35: "Optical response of composite plasma polymer/metal films in the effective medium approach"

## Description

The present invention relates to an amorphous material and, more particularly, to a novel amorphous material comprising a ferromagnetic metal and a polymer.

The existence of so-called amorphous metal in which the arrangement of atoms is irregular has been well known.

Ordinary metals have crystalline structure where atoms are arranged regularly and systematically, but any metal becomes amorphous with disordered atomic arrangement when molten at high temperatures. When metals in the amorphous state are cooled in the usual manner, they return to the original crystalline state. However, some metals, when quenched, solidify in the amorphous state; these are amorphous metals.

These amorphous metals are now utilized in various fields. For example, amorphous Si film is used as a solar cell. Amorphous FeSiB soft magnetic film and Co-Zr system amorphous soft magnetic film are being developed as magnetic cores for power transformers and magnetic film materials for magnetic heads for magnetic recording, respectively, and are in practical use.

An elemental metal becomes amorphous only with difficulty and hence, amorphous films of metal are obtained by mixing, in the molten state, the elemental metal with a metalloid element such as C, B, P, Si or Ge or with a metal such as Zr, Ta or Hf, and then quenching the mixture. The characteristics of the thus obtained metal amorphous films vary greatly depending on concentration of the added metalloid element or metal such as Zr, Ta or Hf.

These alloys have improved corrosion resistance and mechanical strength, as compared with crystalline metals, but in the case of, for example, Co-Cr magnetic material, addition of materials for amorphization such as above mentioned metalloid elements or Zr, Ta or Hf cannot provide sufficient amorphous state and/or give enough corrosion resistance.

The object of the present invention is to provide a novel amorphous material free from the above mentioned defects of the conventional amorphous films and more readily mass-produceable.

Figs. 1 and 5 are diagrammatical views of examples of a batch type and continuous type vacuum deposition apparatus used for production of amorphous films of the present invention.

Figs. 2 (a) and (b) are electron diffraction photographs of the amorphous film of the present invention obtained in Example 1 and a simple film of a control example.

Fig. 3 is a characteristic graph which shows the change in degree of deterioration of the saturation magnetic flux density with time (days) for which the samples were left in a high temperature and humidity atmosphere.

Fig. 4 is a characteristic graph which shows the change in width of a scratch on the surface of samples depending on the number of passes of a diamond needle.

Fig. 6 is a characteristic graph which shows the change of the X-ray diffraction peak of Co.Cr in the (002) plane when the ratio of vapor deposition rate of polyethylene to that of Co.Cr was changed from 0 to 0.19, and Fig. 7 is a characteristic graph which shows the corresponding change in coercive force in the plane.

As the result of the inventors' extensive experiments and researches for a long time, it has been found that a novel amorphous material of a structure containing a ferromagnetic metal and a polymer can be obtained by simultaneous vacuum deposition of a ferromagnetic metal and a polymer at a given deposition rate from separate crucibles or hearths. The present invention is based on this finding and knowledge.

Although the exact mechanism has not yet been elucidated, it is considered that in the amorphous material of the present invention, crystallization of the metal is inhibited so as to produce an amorphous state, since polymer molecules are distributed in the metal at intervals very close to each other and the polymer is integrated with the metal.

In the case of columnar metal particles, it is presumed that some of the polymer covers the outer surface of the metal particles, but polymer molecules are relatively uniformly distributed in the metal column at intervals very close to each other. The same thing applies to particulate metal. The maximum interval between the polymer molecules, at which the metal and the polymer cannot become amorphous has not yet been clarified.

Japanese Patent Examined Publication (Kokoku) No. 3137/82 discloses the production of a magnetic recording medium having a magnetic recording layer formed by simultaneous deposition of a ferromagnetic substance and a polymer on a support by the vapor deposition method.

However, the object of the invention disclosed in that patent publication is to solve the defects of the conventional non-binder type ferromagnetic metal films, namely, generation of saw tooth magnetization transfer areas and occurrence of noise and reduction of recording magnetization caused by eddy currents. According to that invention, since ferromagnetic particles are embedded in the polymer and properly dispersed therein, they behave as single magnetic domain particles and the magnetic characteristics are improved to solve the conventional defects.

Therefore, the polymer in that invention functions merely as an insulating material and does not provide amorphous materials as in the present invention.

According to the simultaneous vapor deposition method disclosed in the above Japanese patent publication, a magnetic layer is formed which comprises alternately laminated metal layers and polymer layers and it is impossible to produce a state, as in the present invention, wherein the polymer molecules are relatively uniformly dispersed at intervals very close to each other in the metal.

In any case, an amorphous material comprising a ferromagnetic metal and a polymer which is contained in the metal has not been disclosed in any literature and is novel.

The term "amorphous material" used here includes not only completely amorphous materials, but also materials containing partially crystalline portions in amorphous substance and materials which are crystallite aggregates which cannot be detected by X-ray diffraction.

It has never been deduced by one skilled in the art before the present invention that a polymer may render amorphous a ferromagnetic metal. Metal becomes amorphous only with difficulty on vacuum deposition of simple metal alone without using polymer.

Unexpectedly, it has been found that an amorphous film formed by simultaneous vapor deposition of ferromagnetic metal and polymer is markedly superior in corrosion resistance and mechanical endurance to that of conventional films obtained by deposition of only simple metal. The exact reason or mechanism for the attainment of this improvement has not yet been elucidated.

The amorphous material of the present invention can be formed as a film on a substance and further can also be used as a mixture prepared by scraping the film from substrate as a powder and mixing it with an appropriate liquid or solid material such as vehicle or binder. In the latter case, the material can be made into shaped products of various forms at a desired time and place by optional means such as coating, spraying or molding.

Therefore, the novel amorphous materials of the present invention can be used not only as magnetic materials, solar cells and magnetic cores of power transformers, but also as hydrogen adsorption and desorption metals. The amorphous hydrogen adsorption and desorption metals made according to the present invention can be used for construction of power storage systems (i.e., a system for storing hydrogen produced by surplus power in hydrogen adsorption and desorption metal and taking out the hydrogen and converting it to electricity when necessary) or high performance power sources which utilize change in hydrogen pressure, or high efficiency heat storage systems which utilize emission and adsorption of heat at the time of adsorption and desorption of hydrogen.

The amorphous material of the present invention can be employed for other uses (e.g., amorphous devices, solid image-taking elements) and besides for various uses (e.g., super-conductive materials) in which amorphous materials can suitably be used.

As explained above, according to the present invention, various ferromagnetic metals can be very easily made amorphous by simultaneous vacuum deposition of a metal and a polymer.

Therefore, the method for producing amorphous material according to the present invention is constitutionally simpler than any conventional method and apparatus per se used therefore is very simple and the practice and operation are also easy.

The amorphous material of the present invention can also be produced by simultaneous sputtering of ferromagnetic metal and polymer.

Metals usable for production of the amorphous material of the present invention are the ferromagnetic metals of the 2nd, 3rd, 4th, 5th and 6th Periods in the Periodic Table. These may be used in the form of the simple substance, alloy or compound.

Polymers usable for the production of amorphous materials of the present invention are linear or network polymers having 10-100, preferably 30-500, more preferably 70-200 carbon atoms. As typical examples thereof, mention may be made of polyethylene, polyethylene terephthalate, polypropylene, polystyrene, polytetrafluoroethylene, polybutadiene, polycarbonate, polyamide, polyimide, polyurethane, polyvinyl chloride, polyvinyl acetate and silicone polymer.

The mixing ratio of metal and polymer is generally such that polymer is at least 5 vol%, preferably at least 10 vol%, more preferably 12-40 vol%. When the amount of polymer is less than 5 vol% the metal cannot be made amorphous. When more than 40 vol%, the metal particle are significantly separated from each other due to the polymer and magnetic characteristics gradually become harder. This is not desired.

The present invention is explained in more detail with reference to the drawings in the following examples.

### Example 1

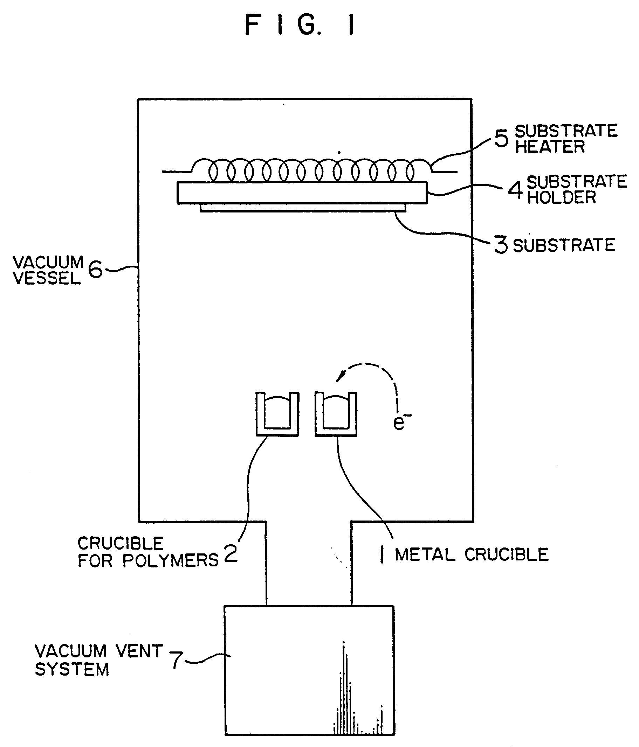

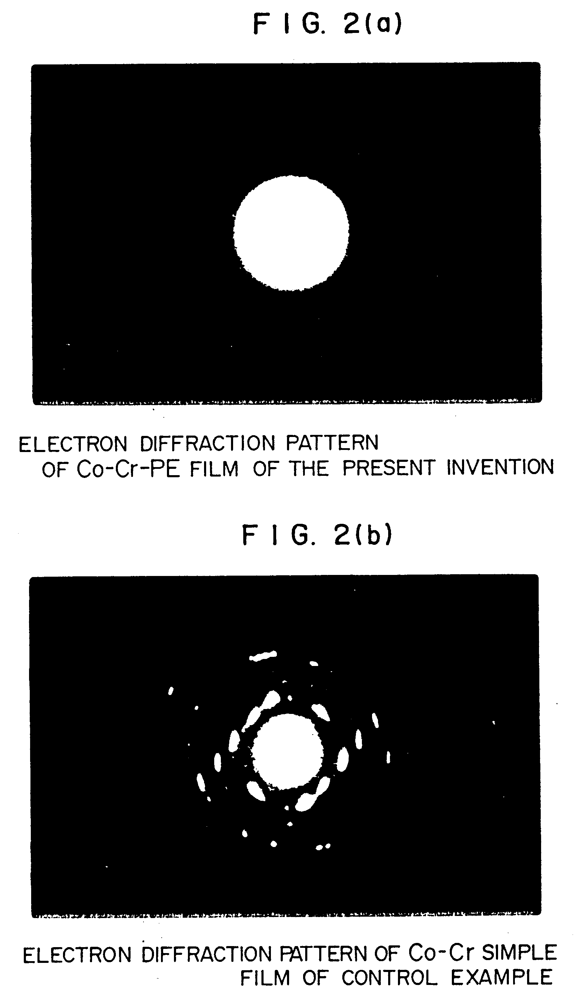

An amorphous film was prepared by simultaneous vacuum deposition of Co.Cr and polyethylene using a batch type vacuum deposition apparatus as shown in Fig. 1 under the following conditions. In Fig. 1, 1 and 2 are crucibles for metal and polymer, respectively, 3 is a substrate, 4 is a substrate holder, 5 is a heater for heating the substrate, 6 is a vacuum vessel and 7 is a vacuum vent system.
1. Metal: Co.Cr
2. Polymer: Polyethylene (average molecular weight: 1000)
3. Substrate: Polyimide film (thickness: 50 µm)
4. Substrate temperature: 150°C
5. Vapor deposition rate: Co.Cr 15x10⁻¹⁰m (15Å/sec) Polyethylene 45x10⁻¹⁰m (4.5 Å/sec)
6. Degree of vacuum: 1∼2x133.322x10⁻⁵Pa (1∼2X10⁻⁵ Torr)

Co.Cr was vapor deposited by electron gun heating and polyethylene was deposited by resistance heating. Thickness of the deposited film was 0.16 µm. Concentration of Cr for Co in the deposited film was 16 wt%.

For comparison, a Co.Cr simple film was prepared under the same conditions as above except that a degree of vacuum of 1∼2x133.322x10⁻⁶ Pa (1∼2 x 10⁻⁶ Torr) was employed.

In order to examine whether the thus obtained Co.Cr + polyethylene film of the present invention was amorphous or not, the film was subjected to X-ray diffraction and electron diffraction to find that no peak was seen in the range of 2ϑ = 20° - 100° in the X-ray diffraction and only two halo rings appeared in the electron diffraction. Thus, it was recognized that the film was amorphous.

On the other hand, in the case of the Co.Cr simple film, there appeared steep peak at 2ϑ = 44.2° due to (002) plane of h.c.p. structure and diffraction pattern was obtained due to h.c.p. structure in electron diffraction. Thus, it was recognized that the Co.Cr simple film was crystalline.

Electron diffraction patterns of the Co.Cr + polyethylene film of the present invention and the control Co.Cr simple film are shown in Fig. 2 (a) and (b), respectively. As is clear therefrom, the Co.Cr. + polyethylene film of the present invention was amorphous while the control Co.Cr simple film remained crystalline.

Magnetic properties of the Co.Cr + polyethylene film of the present invention and those of the control Co.Cr simple film were measured. Saturation magnetic flux density Bs and coercive force Hc were measured by a vibrating sample magnetometer and anisotropic magnetic field Hk was measured by a torque meter. The results are shown in the following Table 1.

**Table 1**

| | Saturation magnetic flux density Bs T(G) | Coercive force Hc A/m (Oe) | Anisotropic magnetic field Hk (A/m (Oe) |
|---|---|---|---|
| Co.Cr-PE film | 6200x10⁻⁴ (6200) | 8.0x10³/4Π (8.0) | 54x10³/4Π (54) |
| Co.Cr film | 6700x10⁻⁴ (6700) | 200x10³/4Π (200) | 5000x10³/4Π (5000) |

In the above Table, the values of coercive force and anisotropic magnetic field are those measured within the face.

As is clear from the results as shown in Table 1, the amorphous Co.Cr + polyethylene film of the present invention had soft magnetic properties.

Moreover, corrosion resistance and mechanical endurance of the Co.Cr + polyethylene film of the present invention and the control Co.Cr simple film were measured.

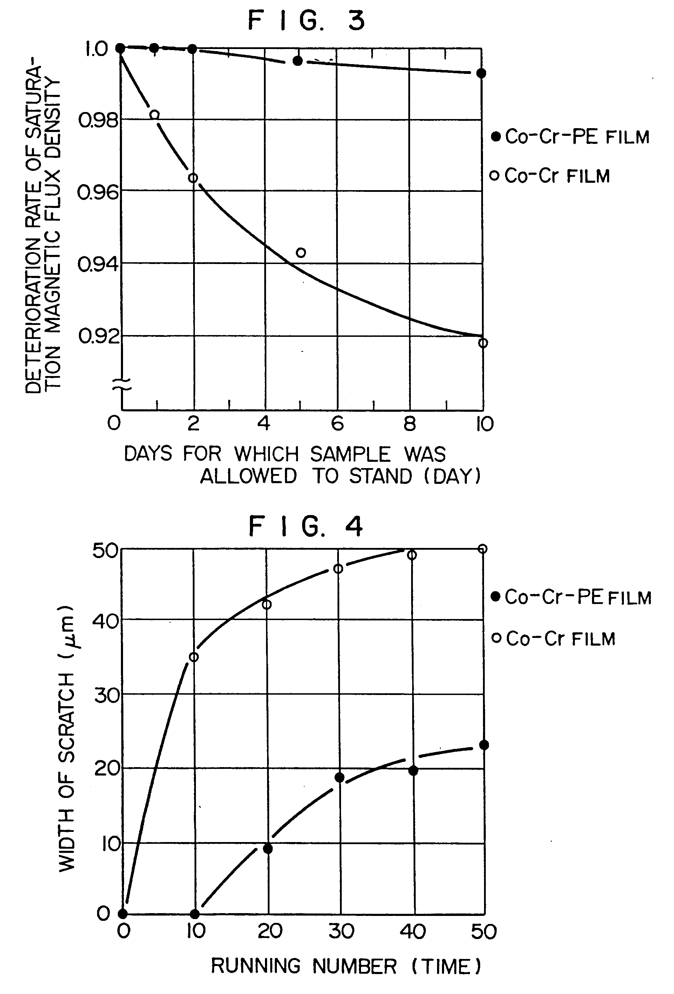

Corrosion resistance was determined by allowing the films to stand in a high temperature and high humidity atmosphere of 60°C and 90%RH for 10 days and measuring deterioration rate (Bs'/Bso) of saturation magnetic flux density. Bso is a saturation magnetic flux density before exposure to the high temperature and high humidity atmosphere and Bs' is a saturation magnetic flux density after exposure to said atmosphere. The saturation magnetic flux density was measured by a vibrating sample magnometer. The results are shown in Fig. 3.

As is clear from the graph of Fig. 3, the Co.Cr + polyethylene film of the present invention was hardly corroded even when it was exposed to high temperature and high humidity atmosphere for a long time as compared with the control Co.Cr simple film and thus it will be seen that the film of the present invention is superior in corrosion resistance.

Mechanical endurance was measured in the following manner: The sample film cut to a strip of 10 mm x 50 mm was pasted on a slide glass. A diamond needle (curvature radius of the tip: 50 µmR) was allowed to reciprocatingly run on the surface of the sample under a load of 4.9x10⁻³N (5 gf) and at a running speed of 14 m/min and the scratch formed on the surface of the sample was observed by a microscope. Changes in width of the scratch depending on the number of running number are shown in Fig. 4.

As is clear from Fig. 4, width of the scratch on the Co.Cr + polyethylene film of the present invention was narrower than that of the scratch on the control Co.Cr simple film and thus is superior in mechanical endurance.

### Example 2

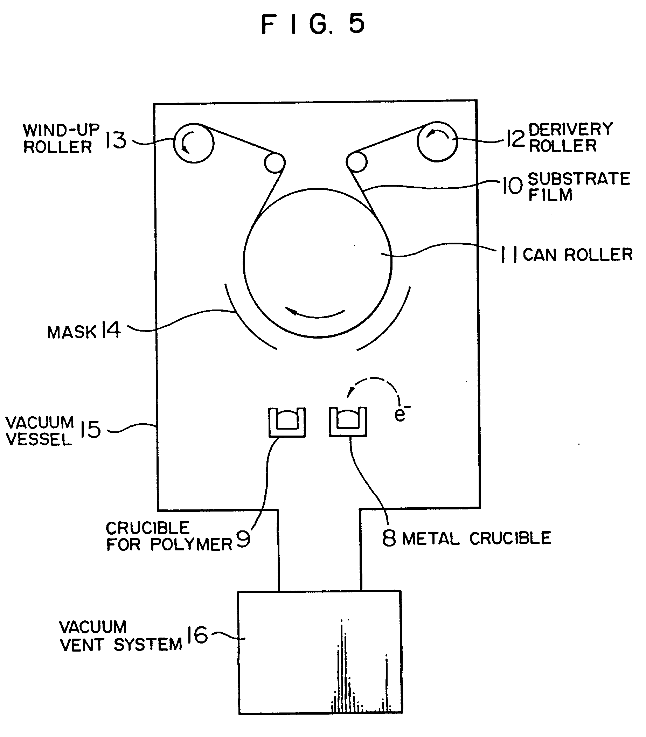

Amorphous films were prepared by simultaneous vapor deposition of metal and polymer by the continuous type vapor deposition apparatus as shown in Fig. 5 under the following conditions. In Fig. 5, 8 is a crucible for metal, 9 is crucible for polymer, 10 is a substrate film, 11 is a can roller, 12 is a delivery roller, 13 is an windup roll and 14 is a mask.
1. Metal: Fe or Co
2. Polymer: Polyethylene (average molecular weight: 1000)
3. Substrate: Polyimide film (thickness: 50 µm)
4. Vapor deposition rate: Fe, Co 500x10⁻¹⁰ m/s (500 Å/sec) Polymer 150x10⁻¹⁰ m/s (150 Å/sec)
6. Degree of Vacuum: 2.0x133.322x10⁻⁵Pa (2.0 x 10⁻⁵ Torr)

The metal was vapor deposited by electron gun heating and the polymer was vapor deposited by resistance heating. Thickness of the deposited film was 10 µm. The polyimide film was a continuous film of 100 m and the amorphous film was deposited along the whole length of the film. Thus, there were obtained two samples of a film of 100 m long having an amorphous film comprising Fe-PE and a film of 100 m long having an amorphous film comprising Co-PE.

In order to examine whether the deposited films of Fe-PE and Co-PE became amorphous or not, 100 test specimens were prepared for each film by cutting each film at an interval of 1 m. All of these test specimens were subjected to X-ray diffraction analysis to find that all of them showed no peaks in the range of angle of diffraction 2ϑ = 20° - 100° and they were amorphous.

Magnetic properties were examined on the same specimens in nearly the same manner as in Example 1. The results are shown in the following Table 2.

**Table 2**

| | Saturated magnetic flux density Bs T(G) | Coercive force Hc A/m (Oe) | Anisotropic magnetic field Hk A/m (Oe) |
|---|---|---|---|
| Co-PE film | 13000x10⁻⁴ (13000) | 8.0x10³/4Π (8.0) | 28x10³/4Π (28) |
| Fe-PE film | 15000x10⁻⁴ (15000) | 2.0x10³/4Π (2.0) | 15x10³/4Π (15) |

In the above Table, the values of coercive force and anisotropic magnetic field are those measured in the plane. The values shown in the Table are averages of those obtained on the 100 specimens.

As is clear from the above results, the Co-PE amorphous and Fe-PE amorphous film of the present invention both showed soft magnetic properties. These properties were very stable along the length of 100 m, namely, ±5% for Bs, ±20% for Hc and ±15% for Hk.

Upper limit of vapor deposition rate in the Co-PE system is preferably such that which satisfies PE deposition rate/Co deposition rate ≦ 0.4. When it exceeds 0.4, Co particles are remotely separated from each other by PE and magnetic properties become harder, resulting in unfavorable effects.

Thus, according to the method of the present invention which comprises simultaneously vacuum depositing ferromagnetic metal and polymer, there was obtained an amorphous soft magnetic film at high deposition rates which can never be attained by the conventional sputtering method and at a probability of nearly 100%.

As is clear from the above explanation and experimental results, according to the method of the present invention, useful amorphous materials can be mass-produced easily and at low cost.

### Example 3

In this example, changes in degree of amorphousness and magnetic properties of Co·Cr-PE film with change in vapor deposition rate of polyethylene with respect to that of Co·Cr were examined. That is, samples were prepared with changing ratio of deposition rate of polyethylene to that of Co·Cr from 0 to 0.19. Other deposition conditions were nearly the same as those employed in Example 1. (Cr concentration for Co was 24 wt%.)

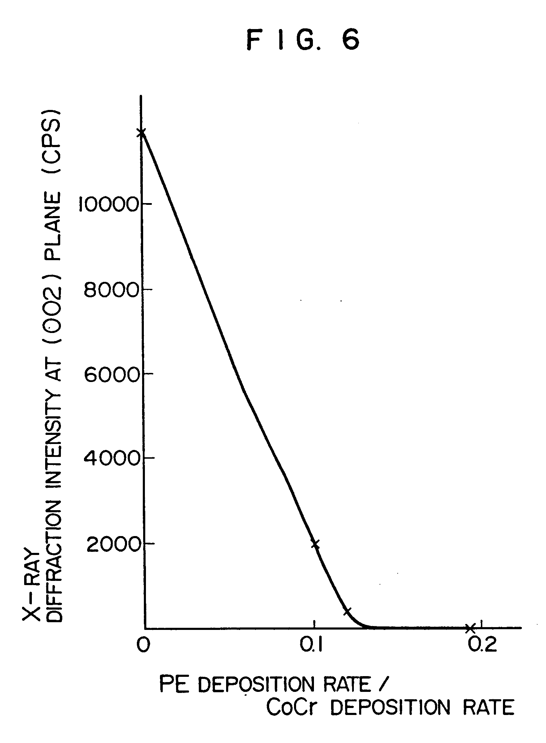

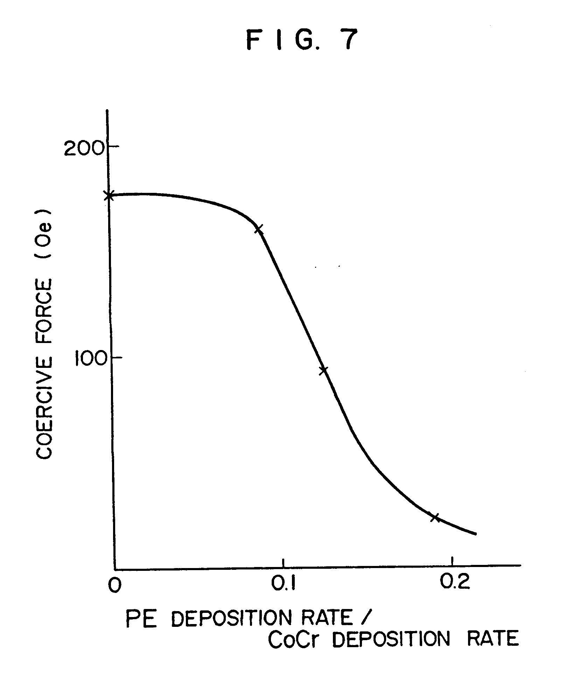

Changes of peaks at (002) plane according to X-ray diffraction of Co·Cr when ratio of vapor deposition rate of polyethylene to that of Co·Cr was changed from 0 to 0.19 are shown in Fig. 6 and changes of coercive force in the plane are shown in Fig. 7.

From these results, it will be seen that the ratio of vapor deposition rate of polyethylene to that of Co·Cr is desirably at least 0.1 from the point of magnetic properties and at least 0.05 from the point of crystal state according to X-ray diffraction.

As explained hereabove, according to the present invention, a novel amorphous material consisting of a ferromagnetic metal and 5 to 40 vol% of a polymer is obtained. The novel amorphous material of the present invention can be shaped not only to a film, but also to products of various forms and thus can be employed for a wide variety of uses as compared with conventional amorphous materials composed of only metals.

The amorphous material of the present invention can be produced by a novel method which comprises simultaneous vacuum deposition of a metal or metalloid and a polymer at a specific ratio of deposition rate. According to the present method, useful amorphous materials can be mass-produced easily, in high yields and at markedly low costs as compared with the conventional various methods for production of amorphous metals.

## Claims

1. An amorphous material which consists of a metal and 5 to 40 vol% of a polymer, the polymer being distributed in the metal and the metal being selected from the ferromagnetic metals of the 2nd, 3rd, 4th, 5th and 6th periods in the Periodic Table.

2. A material according to claim 1 wherein the polymer contains 10-1000 carbon atoms.

3. A material according to claim 2 wherein the polymer contains 30-500 carbon atoms.

4. A material according to any one of claims 1 to 3 comprising 5-40 vol% of the polymer.

5. A material according to any one of claims 1 to 4 wherein the polymer is selected from polyethylene, polyethylene terephthalate, polypropylene, polystyrene, polytetrafluoroethylene, polybutadiene, polycarbonate, polyamide, polyimide, polyurethane, polyvinyl chloride, polyvinyl acetate and silicone polymer and mixtures thereof.

6. A material according to any one of claims 1 to 5 wherein the ferromagnetic metal is selected from Fe, Co, Fe alloy and Co alloy and mixtures thereof.

7. A process for producing an amorphous material according to claim 1 which process comprises simultaneously vacuum depositing or sputtering the metal and polymer.

8. A process according to claim 7 wherein the ferromagnetic metal is in the form of a simple substance, an alloy or a compound.

9. A process according to claim 7 or claim 8 for producing a material according to any one of claims 2 to 6.

## Patentansprüche

1. Amorphes Material, das aus einem Metall und 5 bis 40 Vol.-% eines Polymers besteht, wobei das Polymer im Metall verteilt ist und das Metall unter den ferromagnetischen Metallen der zweiten, dritten, vierten, fünften und sechsten Perioden im Periodischen System gewählt ist.

2. Material nach Anspruch 1, wobei das Polymer 10-1000 Kohlenstoffatome enthält.

3. Material nach Anspruch 2, wobei das Polymer 30-500 Kohlenstoffatome enthält.

4. Material nach irgendeinem der Ansprüche 1 bis 3, das 5 bis 40 Vol.-% des Polymers aufweist.

5. Material nach irgendeinem der Ansprüche 1 bis 4, wobei das Polymer unter Polyethylen, Polyethylenterephthalat, Polypropylen, Polystyrol, Polytetrafluorethylen, Polybutadien, Polykarbonat, Polyamid, Polyimid, Polyurethan, Polyvinylchlorid, Polyvinylacetat und Siliconpolymer und Mischungen davon gewählt ist.

6. Material nach irgendeinem der Ansprüche 1 bis 5, wobei das ferromagnetische Metall unter Fe, Co, Fe-Legierung und Co-Legierung und Mischungen davon gewählt ist.

7. Verfahren zur Herstellung eines amorphen Materials nach Anspruch 1, welches Verfahren eine gleichzeitige Vakuumabscheidung oder -zerstäubung des Metalls und des Polymers vorsieht.

8. Verfahren nach Anspruch 7, wobei das ferromagnetische Metall in der Form eines einfachen Stoffes, einer Legierung oder einer Verbindung ist.

9. Verfahren nach Anspruch 7 oder Anspruch 8 zur Herstellung eines Materials nach irgendeinem der Ansprüche 2 bis 6.

## Revendications

1. Matériau amorphe qui est constitué d'un métal et de 5 à 40% en volume d'un polymère, le polymère étant réparti dans le métal et le métal étant choisi parmi les métaux ferromagnétiques des seconde, troisième, quatrième, cinquième et sixième périodes du tableau périodique.

2. Matériau selon la revendication 1, dans lequel le polymère contient 10 à 1000 atomes de carbone.

3. Matériau selon la revendication 2, dans lequel le polymère contient 30 à 500 atomes de carbone.

4. Matériau selon l'une quelconque des revendications 1 à 3, comprenant 5 à 40% en volume du polymère.

5. Matériau selon l'une quelconque des revendications 1 à 4, dans lequel le polymère est choisi parmi le polyéthylène, le poly(téréphtalate d'éthylène), le polypropylène, le polystyrène, le polytétrafluoroéthylène, le polybutadiène, les polycarbonates, les polyamides, les polyimides, les polyuréthanes, le poly(chlorure de vinyle), le poly(acétate de vinyle), les polymères du type silicone et leurs mélanges.

6. Matériau selon l'une quelconque des revendications 1 à 5, dans lequel le métal ferromagnétique est choisi parmi Fe, Co, les alliages de Fe, les alliages de Co et leurs mélanges.

7. Procédé de production d'un matériau amorphe selon la revendication 1, qui comprend le dépôt sous vide ou la pulvérisation du métal et du polymère, simultanément.

8. Procédé selon la revendication 7, dans lequel le métal ferromagnétique est sous la forme d'un élément simple, d'un alliage ou d'un composé.

9. Procédé selon la revendication 7 ou 8, pour la production d'un matériau selon l'une quelconque des revendications 2 à 6.
